# DEMANDE DE BREVET EUROPEEN

(11) **EP 0 920 036 A1**
(43) Date de publication de la demande: **02.06.1999**
(21) Numéro de dépôt: 98410135.2
(22) Date de dépôt: 27.11.1998
(51) Int. Cl.: H01F 27/28, H01F 41/04, H01L 21/3205

(54) **Transformateur en circuit intégré**

(30) Priorité: 28.11.1997 FR 9715333
(71) Demandeur: STMicroelectronics SA, 94250 Gentilly Cedex (FR); FRANCE TELECOM, 75015 Paris (FR)
(72) Inventeur: Marty, Michel, 38760 Saint Paul de Varces (FR); Jaouen, Hervé, 38240 Meylan (FR)
(74) Mandataire: de Beaumont, Michel

(57) **Abrégé**

L'invention concerne un transformateur formé dans un circuit intégré comprenant quatre niveaux de lignes conductrices (10, 12, 14, 16), séparés par des première, deuxième et troisième couches isolantes. Des premiers vias conducteurs (34) s'étendent à travers la deuxième couche isolante (56), reliant les deuxièmes et troisièmes lignes conductrices, et forment avec les deuxièmes et troisièmes lignes conductrices un premier enroulement (33). Des deuxièmes vias conducteurs (38) s'étendent à travers les première, deuxième et troisième couches isolantes, reliant les premières et quatrièmes lignes conductrices, et forment avec les premières et quatrièmes lignes conductrices un second enroulement (36) autour du premier enroulement et de façon sensiblement concentrique à celui-ci.

## Description

La présente invention concerne la fabrication d'inductances dans des circuits intégrés. Plus particulièrement, elle concerne la fabrication de transformateurs de haute qualité dans des circuits intégrés monolithiques.

De nombreuses structures ont été proposées pour la fabrication d'inductances ou de transformateurs dans des circuits intégrés. Certaines structures comprennent un agencement en spirale d'une piste conductrice disposée dans un plan parallèle au substrat semiconducteur. En disposant plusieurs de ces structures spirales en communication magnétique, on forme un transformateur.

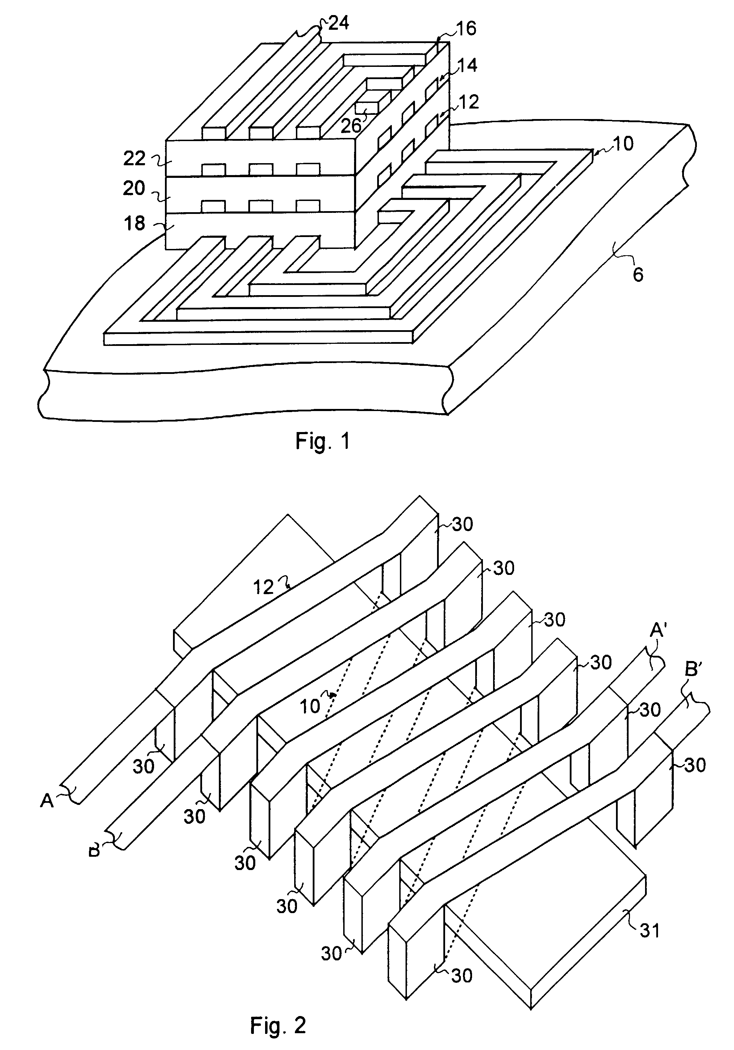

La figure 1 représente un transformateur constitué de plusieurs inductances spirales planes tel que décrit par Burghartz et al. dans IEEE Transactions on Electron Devices, vol. 43, N° 9, septembre 1996. Sur un substrat 6, une inductance spirale est formée dans chacune de plusieurs couches conductrices 10, 12, 14, 16 séparées par des couches isolantes 18, 20, 22. Un contact électrique est assuré à chaque extrémité 24, 26 de chaque inductance spirale. En raison du couplage magnétique entre les spirales, un signal alternatif sur l'une des spirales pourra être détecté sur certaines ou toutes les autres spirales, ce qui assure une fonction de transformateur.

Un tel transformateur présente trois inconvénients majeurs.

Premièrement, le couplage électromagnétique entre les couches spirales est faible puisque les distances entre spirales successives 10, 12 sont définies par l'épaisseur d'une couche diélectrique interniveau 18. Les couches diélectriques interniveau sont suffisamment épaisses pour éviter l'apparition de capacités parasites entre conducteurs de couches conductrices successives, ailleurs dans le circuit intégré. Elles ont typiquement une épaisseur de 1 µm.

Il y aura en conséquence un faible coefficient de couplage entre les spirales 10, 12 et le facteur de mérite du transformateur résultant, défini par le rapport entre le produit courant/tension d'un signal d'entrée sur un enroulement primaire et le produit courant/tension du signal de sortie sur un enroulement secondaire est faible.

Deuxièmement, le champ électromagnétique produit par les inductances spirales est sensiblement vertical, perpendiculaire à la surface du substrat 6. En fonctionnement, une quantité notable de champ électromagnétique pénétrera dans le substrat 6. Ceci constitue un inconvénient car une tension est en conséquence induite dans le substrat. Cette tension peut provoquer des courants de fuite ; peut rendre passant certains composants à l'intérieur du circuit intégré ; et peut modifier les caractéristiques de fonctionnement de composants du circuit intégré, de sorte que le circuit intégré ne fonctionne plus.

A titre de variante, un plan de masse pourrait être placé sur la couche conductrice la plus basse 10. Toutefois, ceci augmenterait la capacité parasite associée à la structure et réduirait le facteur de mérite des transformateurs résultants. L'introduction d'une plaque conductrice peut également entraîner des effets d'antenne indésirables.

Troisièmement, le transformateur illustré occupe une grande surface sur le substrat 6. Le document cité mentionne une surface de 226 µm x 226 µm pour une inductance spirale de 3 à 6 tours, et une inductance de 1,4 à 11 nH.

La figure 2 représente un autre transformateur de l'art antérieur pour circuits intégrés, tel que décrit dans la demande de brevet européen EP-A-0 725 407. En utilisant deux couches conductrices 10, 12 et une succession de vias 30, on forme deux enroulements concentriques entrelacés A-A', B-B', bobinés autour d'un noyau ferromagnétique 31. Ce transformateur assure un couplage accru entre l'enroulement primaire A-A' et l'enroulement secondaire B-B'. La surface du substrat occupée par cette structure est encore relativement grande. La surface sera définie dans la direction de la largeur, par la dimension nécessaire du noyau ferromagnétique, par l'écart requis entre celui-ci et les vias 30 des enroulements et par la dimension des vias, et dans la direction de la longueur, par l'espacement entre pistes métalliques voisines et par le nombre requis de tours. Pour chaque tour des enroulements primaire et secondaire, on forme deux enroulements autour du noyau 31, ce qui signifie que le transformateur résultant est deux fois plus long que le serait une inductance simple ayant le même nombre de tours qu'un enroulement du transformateur.

L'utilisation de matériaux ferromagnétiques requis pour fabriquer le noyau 31 n'est pas complètement maîtrisée dans les techniques classiques de fabrication de circuits intégrés. En outre, le couplage entre les enroulements n'est pas très élevé, bien qu'il soit amélioré par rapport à celui de la structure de la figure 1.

Un objet de la présente invention est de prévoir une structure de transformateur destinée à être utilisée dans un circuit intégré dans laquelle le couplage entre les enroulements primaire et secondaire est élevé.

Un objet de la présente invention est de prévoir une telle structure de transformateur qui réduise l'émission de champ électromagnétique dans le substrat.

Un objet de la présente invention est de prévoir une telle structure de transformateur qui occupe une surface réduite sur le substrat.

Un objet de la présente invention est de prévoir une telle structure de transformateur qui soit compatible avec les procédés de fabrication classiques et ne nécessite pas d'étape de traitement spécifique ou de matériau spécifique.

Ainsi la présente invention prévoit un transformateur formé dans un circuit intégré comprenant un substrat de surface supérieure horizontale, comprenant une première pluralité de lignes conductrices disposées en une première couche sur la surface supérieure du substrat ; une deuxième pluralité de lignes conductrices disposées en une deuxième couche, séparées verticalement de la première pluralité de lignes conductrices par une première couche isolante ; une troisième pluralité de lignes conductrices disposées en une troisième couche, séparées verticalement de la deuxième pluralité de lignes conductrices par une deuxième couche isolante ; une quatrième pluralité de lignes conductrices disposées en une quatrième couche, séparées verticalement de la troisième pluralité de lignes conductrices par une troisième couche isolante ; des premiers vias conducteurs s'étendant à travers la deuxième couche isolante, reliant les deuxième et troisième lignes conductrices, d'où il résulte que les deuxième et troisième pluralité de lignes conductrices et les premier vias conducteurs forment un premier enroulement ; et des deuxièmes vias conducteurs s'étendant à travers les première, deuxième et troisième couches isolantes, reliant les première et quatrième pluralités de lignes conductrices, d'où il résulte que les première et quatrième pluralités de lignes conductrices et les deuxièmes vias conducteurs forment un second enroulement autour du premier enroulement et de façon sensiblement concentrique à celui-ci.

Selon un mode de réalisation de la présente invention, les axes des premier et second enroulements sont sensiblement parallèles à la surface supérieure du substrat.

Selon un mode de réalisation de la présente invention, chacune de la quatrième pluralité de lignes conductrices est constituée d'une seule pièce avec au moins une partie des deuxièmes vias conducteurs sous-jacents.

Selon un mode de réalisation de la présente invention, chacune de la troisième pluralité de lignes conductrices est constituée d'une seule pièce avec les premiers vias conducteurs sous-jacents, ces ensembles étant en contact électrique direct avec des lignes conductrices respectives sous-jacentes de la deuxième pluralité de lignes conductrices.

Selon un mode de réalisation de la présente invention, les deuxièmes vias conducteurs comprennent des plots dans les deuxième et troisième couches, chaque plot étant constitué d'une seule pièce avec une partie sous-jacente des deuxièmes vias conducteurs respectifs.

Selon un mode de réalisation de la présente invention, chacune de la quatrième pluralité de lignes conductrices est constituée d'une seule pièce avec les deuxièmes vias conducteurs sous-jacents, ces ensembles étant en contact électrique direct avec des lignes respectives sous-jacentes de la première pluralité de lignes conductrices.

Selon un mode de réalisation de la présente invention, les lignes conductrices et les vias conducteurs sont essentiellement constitués de cuivre.

Selon un mode de réalisation de la présente invention, les lignes conductrices et les vias conducteurs sont essentiellement constitués d'aluminium.

Selon un mode de réalisation de la présente invention, les lignes conductrices et les vias conducteurs comprennent en outre une couche de revêtement en nitrure de titane, encapsulant les lignes conductrices et les vias conducteurs sur toutes leurs surfaces autres que leurs surfaces supérieures.

Selon un mode de réalisation de la présente invention, chaque tour de chaque enroulement comprend seulement deux surfaces de contact.

La présente invention prévoit aussi un procédé de fabrication de transformateurs dans des circuits intégrés, comprenant les étapes suivantes :
a) former une première couche diélectrique sur une surface supérieure d'un substrat ;
b) graver la première couche diélectrique selon un motif pour former des cavités qui correspondent à un agencement désiré de premières lignes conductrices ;
c) remplir les cavités dans la première couche diélectrique pour former une première pluralité de lignes conductrices disposées en une première couche ;
d) déposer une première couche isolante ;
e) former une deuxième couche diélectrique sur la surface supérieure de la structure résultante ;
f) graver la deuxième couche diélectrique selon un motif pour former des cavités correspondantes à un agencement désiré de deuxièmes lignes conductrices ;
g) remplir les cavités dans la deuxième couche diélectrique pour former une deuxième pluralité de lignes conductrices agencées en une deuxième couche ;
h) déposer une deuxième couche isolante ;
i) former une troisième couche diélectrique sur la surface supérieure de la structure résultante ;
j) graver la troisième couche diélectrique selon un motif pour former des cavités qui correspondent à un agencement désiré de troisièmes lignes conductrices ;
k) remplir les cavités dans la troisième couche diélectrique pour former une troisième pluralité de lignes conductrices agencées en une troisième couche ;
l) déposer une troisième couche isolante ;
m) former une quatrième pluralité de lignes conductrices agencées en une quatrième couche ;
n) entre les étapes h) et l), mettre en oeuvre les étapes suivantes :
   n1) former des cavités dans la deuxième couche isolante selon un motif qui correspond aux emplacements requis des premiers vias conducteurs ;
   n2) remplir les cavités dans la deuxième couche isolante d'un matériau conducteur pour former des premiers vias conducteurs s'étendant à travers la deuxième couche isolante pour connecter électriquement des lignes respectives des deuxième et troisième pluralités de lignes conductrices pour former un premier enroulement ; et
p) entre les étapes d) et m), mettre en oeuvre les étapes suivantes :
   p1) former des cavités dans les première, deuxième et troisième couches isolantes selon un motif qui correspond aux emplacements requis des deuxièmes vias conducteurs ;
   p2) remplir les cavités dans les première, deuxième et troisième couches isolantes d'un matériau conducteur pour former les premiers vias conducteurs s'étendant à travers les première, deuxième et troisième couches isolantes pour connecter électriquement des lignes respectives des première et quatrième pluralités de lignes conductrices de façon à former un second enroulement autour du premier enroulement et de façon sensiblement concentrique à celui-ci.

Selon un mode de réalisation de la présente invention, l'étape m) comprend les étapes suivantes :
m1) former une quatrième couche diélectrique sur la surface supérieure d'un substrat ;
m2) graver la quatrième couche diélectrique selon un motif pour former des cavités qui correspondent à un agencement désiré de quatrièmes lignes conductrices ;
m3) remplir les cavités dans la quatrième couche diélectrique pour former la quatrième pluralité de lignes conductrices.

Selon un mode de réalisation de la présente invention, à l'étape p1), les cavités sont formées dans les première, deuxième et troisième couches isolantes en une seule étape.

Selon un mode de réalisation de la présente invention, à l'étape p2), le remplissage des cavités dans les première, deuxième et troisième couches isolantes est réalisé en une seule étape.

Selon un mode de réalisation de la présente invention, à l'étape p2), le remplissage des cavités dans les première, deuxième et troisième couches isolantes est réalisé à l'étape m3).

Selon un mode de réalisation de la présente invention, à l'étape p1), les cavités sont formées dans les deuxième et troisième couches isolantes en une seule étape.

Selon un mode de réalisation de la présente invention, à l'étape p2), le remplissage des cavités dans les deuxième et troisième couches isolantes est réalisé en une seule étape.

Selon un mode de réalisation de la présente invention, à l'étape p2), le remplissage des trous dans les deuxième et troisième couches isolantes est réalisé à l'étape m3).

Un mode de réalisation particulier de la présente invention va être décrit à titre d'exemple en faisant référence aux dessins joints parmi lesquels :
la figure 1 représente un transformateur pour circuit intégré selon l'art antérieur ;
la figure 2 représente un autre transformateur pour circuit intégré selon l'art antérieur ;
la figure 3 représente une vue en perspective d'un transformateur pour circuit intégré selon la présente invention ;
les figures 4A à 7B représentent des vues en coupe de modes de réalisation d'un transformateur pour circuit intégré selon la présente invention ; et
la figure 8 représente une vue de dessus d'un mode de réalisation d'un transformateur selon la présente invention.

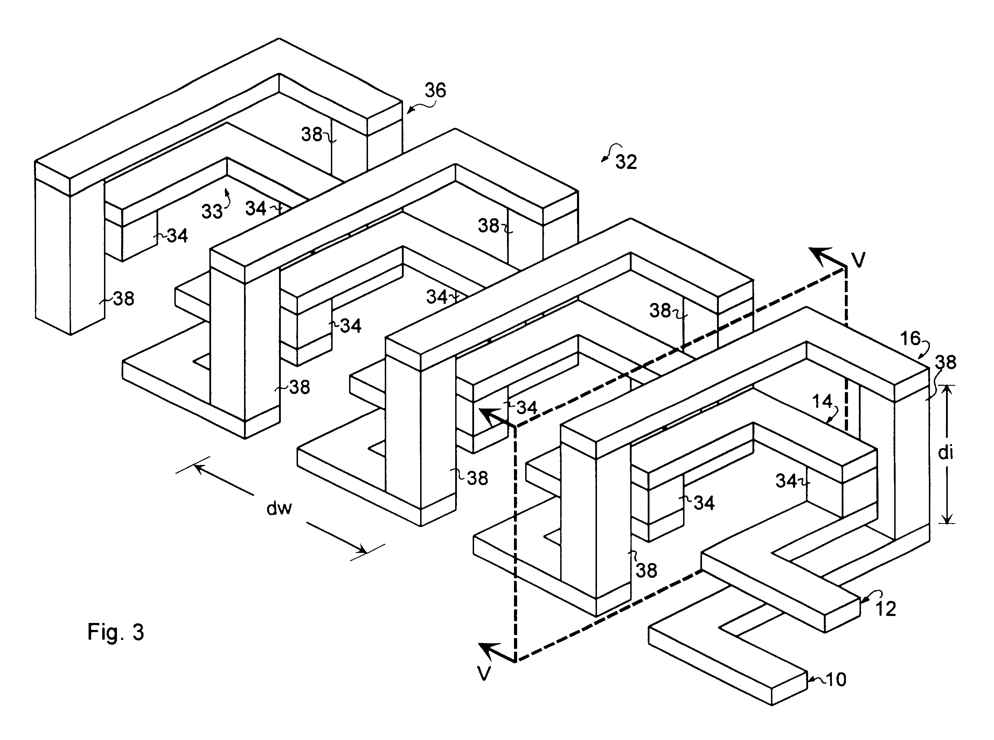

La figure 3 représente un transformateur 32 pour circuit intégré selon l'invention. Par souci de clarté le substrat 6 et diverses couches sont omises du schéma. Quatre couches conductrices 10, 12, 14, 16 sont utilisées.

L'enroulement primaire 33 est constitué de lignes conductrices des deuxième 12 et troisième 14 couches, et de premiers vias 34. Les deuxième et troisième couches conductrices sont conformées pour constituer des lignes conductrices, par exemple en forme de L, qui sont connectées les unes aux autres par les premiers vias 34 pour former un enroulement 33 dont l'axe est sensiblement parallèle au substrat sur lequel la structure de transformateur est constituée.

Un enroulement secondaire 36 est constitué à partir des première 10 et quatrième 16 couches conductrices et de deuxièmes vias 38. Les première et quatrième couches conductrices sont gravées, par exemple en forme de L et connectées les unes aux autres par des deuxièmes vias 38 pour former l'enroulement secondaire 36 autour et de façon sensiblement concentrique à l'enroulement primaire 33, et ayant un axe sensiblement parallèle à la surface supérieure de substrat sur laquelle la structure de transformateur 32 est formée.

Le pas dw entre les enroulements adjacents a été exagéré par souci de clarté. A l'intérieur de deux longueurs de pas dw, deux tours complets des enroulements primaire 33 et secondaire 36 sont réalisés. Sur une longueur correspondante de la structure de la figure 2, un seul tour de chacun des enroulements primaire A-A' et secondaire B-B' est réalisé.

Dans l'exemple illustré en figure 3, les enroulements primaire 33 et secondaire 36 présentent un même nombre de tours. Le transformateur 32 agira donc comme un transformateur d'isolement qui ne multiplie ni ne divise une tension appliquée à l'enroulement primaire 33. En modifiant le rapport entre les nombres de tours des enroulements 33 et 36 on pourra réaliser des transformateurs élévateurs et abaisseurs.

Des tours voisins de chacun des enroulements primaire 33 et secondaire 36 peuvent être agencés de façon aussi serrée que cela est autorisé par les règles de conception du procédé de fabrication utilisé. Il est avantageux que les tours de chaque enroulement soient disposés aussi près que possible les uns des autres pour assurer un couplage maximum entre les enroulements primaire 33 et secondaire 36. En resserrant autant que possible les tours, la surface du substrat occupée par la structure du transformateur 32 peut être rendue minimale. Toutefois, un resserrement excessif des tours de chaque enroulement pourrait provoquer l'apparition d'une capacité parasite excessivement grande entre tours adjacents d'un même enroulement. L'écart horizontal entre tours de chaque enroulement peut être librement choisi pourvu qu'un écart minimum soit assuré, comme cela est défini par les règles de dessins respectives. Pour rendre minimal le couplage capacitif indésirable entre tours adjacents d'un même enroulement, un pas dw de 4.5 µm ou plus est souhaitable.

L'écart vertical di entre couches conductrices est déterminé par l'épaisseur des couches diélectriques utilisées dans le processus de fabrication particulier utilisé. Une épaisseur classique typique d'une couche isolante se trouvant entre couches conductrices est d'environ 1 µm. La séparation verticale entre la première couche 10 et la quatrième couche 16 sera équivalente à l'épaisseur totale des trois couches diélectriques se trouvant entre les couches conductrices respectives, l'épaisseur des deuxième et troisième couches conductrices et l'épaisseur de toute autre couche de masquage étant incluse. Ceci donne un écart vertical total di typiquement d'au moins 3 à 4 µm, ce qui est suffisant pour réduire le couplage capacitif entre les diverses couches à un niveau acceptable.

La structure de transformateur représentée en figure 3 assure un facteur de couplage élevé entre enroulements étant donné que l'enroulement primaire 33 est entouré par l'enroulement secondaire 36. Le transformateur 32 présentera donc un facteur de mérite élevé.

Le champ électromagnétique produit par l'enroulement primaire 33 est sensiblement parallèle au substrat, de sorte qu'une très petite partie du champ électromagnétique pénétrera dans le substrat. En outre, la facteur de couplage avec l'enroulement secondaire est tellement élevé qu'une très petite partie du champ électromagnétique s'échappera de l'enroulement secondaire. Aucun écran de masse n'est nécessaire avec la structure de transformateur selon l'invention.

Après cette description des aspects fondamentaux de l'invention, on va décrire ci-après plusieurs variantes de réalisation de la structure de la figure 3. Toutes les figures utilisées pour représenter ces modes de réalisation sont des vues en coupe prises dans le plan V en regardant dans la direction représentée par des flèches en figure 3.

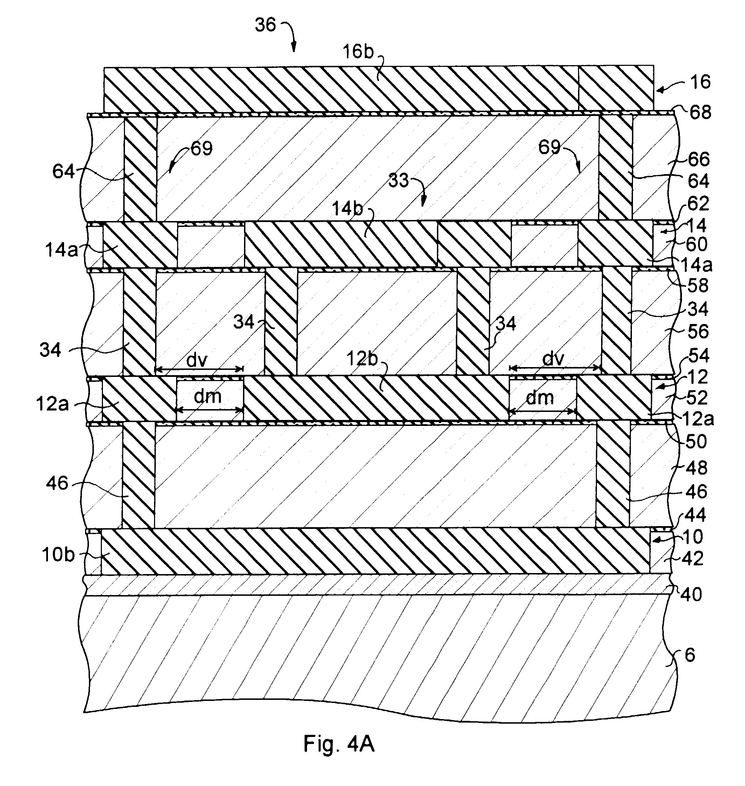

La figure 4A représente un mode de réalisation de la structure de transformateur intégrée selon l'invention utilisant un procédé de formation de motifs de type simple damascène pour les couches conductrices et les vias. Le substrat 6 peut être recouvert d'une couche isolante 40, par exemple une couche d'oxyde de champ. Une première couche diélectrique 42 est alors formée sur la couche d'oxyde de champ 10. Puis on forme une première couche de masquage 44 gravée selon le motif requis pour la première couche 10 de lignes conductrices. La première couche diélectrique 42 est gravée, par exemple en utilisant une gravure anisotrope sélective par l'intermédiaire de la première couche de masquage 44. Une gravure appropriée est une gravure plasma utilisant un composé au fluorocarbone tel que C₄F₈ pour une couche de masquage en nitrure de silicium 44 sur une couche diélectrique 42 à base d'oxyde de silicium. La sélectivité de ces produits de gravure augmente avec la proportion de carbone présente, de sorte que C₄F₈ est plus sélectif que CF₄. Les cavités ainsi formées sont remplies de matériau conducteur pour former les lignes conductrices de la première couche 10. Ceci peut être réalisé par dépôt sélectif ou en déposant le matériau de la première couche conductrice 10 sur toute la surface restante de la première couche de masquage 44, et à l'intérieur des cavités, puis en enlevant le matériau recouvrant la couche de masquage par une étape de polissage ou par une étape de gravure humide ou à sec. Ceci est le procédé classique dit simple damascène bien connu de l'homme de l'art.

D'autres couches diélectriques et de masquage sont déposées et des étapes similaires sont utilisées pour former :
- des vias 46 dans une première couche isolante 48 sur une deuxième couche de masquage 50 ;
- une deuxième couche 12 de lignes conductrices 12a, 12b dans une deuxième couche diélectrique 52 sous une troisième couche de masquage 54 ;
- des vias 34 dans une deuxième couche isolante 56 sous une quatrième couche de masquage 58 ;
- une troisième couche 14 de lignes conductrices 14a, 14b dans une troisième couche diélectrique 60 sous une cinquième couche de masquage 62 ; et
- des vias 64 dans une troisième couche isolante 66 sous une sixième couche de masquage 68.

Chaque couche 12, 14 comporte des plots conducteurs 12a, 14a recouvrant des emplacements choisis pour la formation de vias 34, 64 dans la couche isolante suivante. Ces plots ont typiquement une largeur et une longueur de deux à trois fois le diamètre des vias. Il doivent être séparés de lignes conductrices voisines 12b, 14b de l'enroulement primaire 33 d'au moins l'écart minimum dm autorisé par la filière de fabrication utilisée.

La quatrième couche 16 de lignes conductrices 16b peut être formée de façon similaire en utilisant le processus décrit ci-dessus de type simple damascène ou peut être déposée ou gravée par tout autre procédé, comme cela convient pour le procédé de fabrication du circuit intégré dont le transformateur selon l'invention fait partie.

Etant donné que chaque empilement de vias et de plots conducteurs 46, 12a, 34, 14a, 64 sert seulement à connecter une ligne conductrice 16b à une autre ligne conductrice 10b, chaque empilement pourrait être considéré comme un via unique 69 traversant les première, deuxième et troisième couches isolantes, les deuxième et troisième couche diélectrique et les couches de masquage.

Chacune des couches 10, 12, 14, 16 de lignes conductrices et les première, deuxième et troisième couches diélectriques 42, 52, 62 peut avoir une épaisseur de 0,5 µm. Chacune des première, deuxième et troisième couches diélectriques 48, 56, 66, incluant les vias 46, 34, 64 peut avoir une épaisseur de 1 µm. Les couches de masquage peuvent avoir 0,1 µm d'épaisseur. Les couches de masquage peuvent être constituées de nitrure de silicium. Les couches diélectriques peuvent être constituées d'oxyde de silicium ou d'un verre à base d'oxyde de silicium tel que BPSG, PSG, TEOS. Les lignes conductrices des couches 10, 12, 14, 16 peuvent être constituées de tungstène, de cuivre ou d'aluminium, ou d'autres matériaux conducteurs mais doivent de préférence être constituées d'un matériau de faible résistivité.

Pour faire des transformateurs viables, la résistance de chaque enroulement doit être minimale. Cette résistance comprend la résistance série des lignes conductrices 10b, 12b, 14b, 16b utilisées et la résistance des vias 34, 69 reliant ces lignes les unes aux autres.

Dans des applications à haute fréquence, le nombre de tours requis pour chaque enroulement peut être élevé. En utilisant le procédé de formation de vias de type simple damascène décrit ci-dessus, on peut obtenir les résultats suivants : pour des vias 64, 34, 46 d'un diamètre de 0.5 µm, la résistance de via varie entre 0,2 et 0,5 Ω. Quand une couche barrière ou couche de revêtement est utilisée - par exemple une couche de nitrure de titane TiN sous le tungstène - la résistance de via est augmentée de la résistance de cette couche. Une couche de TiN déposée par voie chimique en phase vapeur (CVD) a une résistivité d'environ 70 µΩ.cm. Pour un via typique, d'une section de 0,4 µm x 0.4 µm, la résistance de chaque via est augmentée d'environ 0,1 Ω par l'inclusion d'une couche de TiN d'une épaisseur de 5 nm.

On a observé que les performances optimales du transformateur nécessite des résistances de via non supérieures à 0.2 Ω par couche de via 46, 34, 64.

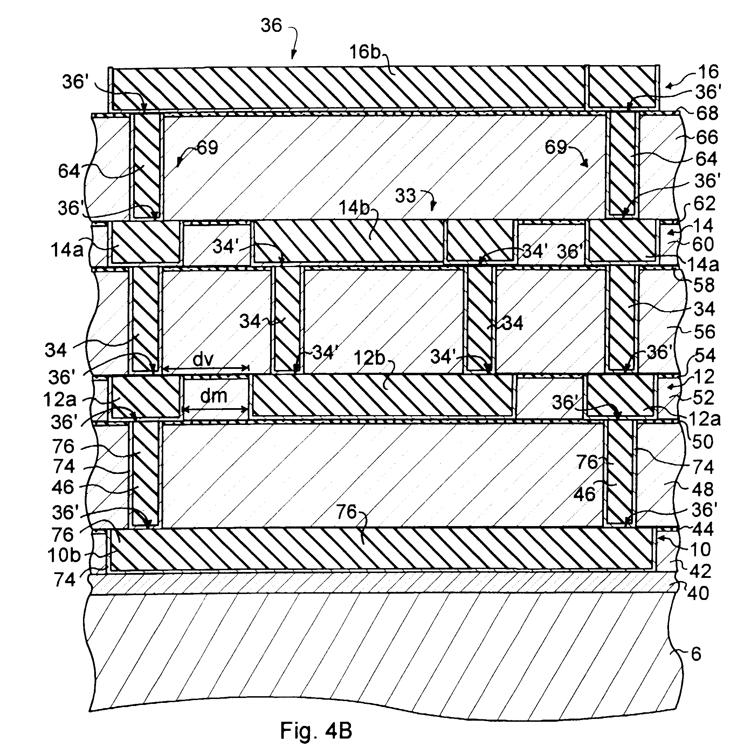

La figure 4B représente une variante du mode de réalisation de la figure 4A. Chaque couche conductrice 10, 12, 14, 16 est formée sensiblement de la façon décrite ci-dessus sauf qu'une couche de revêtement 74 est déposée dans chaque cavité, avant dépôt d'un matériau très conducteur 76. Ensuite, des étapes de polissage ou de gravure sont réalisées pour enlever le matériau très conducteur 76 et la couche de revêtement 74 d'emplacements autre qu'à l'intérieur des cavités. Chaque ligne conductrice et chaque via est encapsulé par la couche de revêtement 74 sur toutes ses surfaces sauf les surfaces supérieures respectives.

De façon similaire pour la formation des vias 46, 34, 64, la couche de revêtement 74 est d'abord déposée dans les cavités, avant qu'un matériau très conducteur 76 ne soit déposé pour remplir les vias.

Des exemples de matériaux convenables pour la couche de revêtement 74 et le matériau très conducteur 76 sont :
1) une couche de titane de 20 nm sous de l'aluminium 76. Dans ce cas, un composé intermétallique TiAl₃ se forme sur une épaisseur d'environ 60 nm, avec une résistivité d'environ 70 µΩ.cm. L'aluminium a une résistivité d'environ 3 µΩ.cm ;
2) une couche de nitrure de titane (TiN) sous du tungstène (W). La résistivité de W est d'environ 12 µΩ.cm ;
3) une couche de TiN de 10 nm sous du cuivre, qui présente une résistivité de seulement environ 1,8 µΩ.cm. Ceci constitue la sélection de matériaux préférée.

Il importe de réduire autant que possible la résistance des vias, puisque chaque tour de chaque enroulement comprend plusieurs couches de vias 46, 34, 64. Toute augmentation de résistance de via augmentera notablement la résistance série totale du transformateur et réduira son facteur de mérite.

Bien que la résistivité des vias détermine pour une grande partie la résistance série de chaque enroulement, la résistance des lignes conductrices peut devenir importante pour une structure de transformateur très longue.

Il sera en conséquence avantageux de réduire à un minimum le nombre de surfaces de contact 34', 36', en particulier le nombre de couches de revêtement 74 devant être traversées par un courant circulant dans les enroulements du transformateur.

Comme on peut le voir en figure 4B, chaque tour de l'enroulement primaire 33 comprend quatre surfaces de contact 34' et chaque tour de l'enroulement secondaire 36 comprend 12 surfaces de contact 36'.

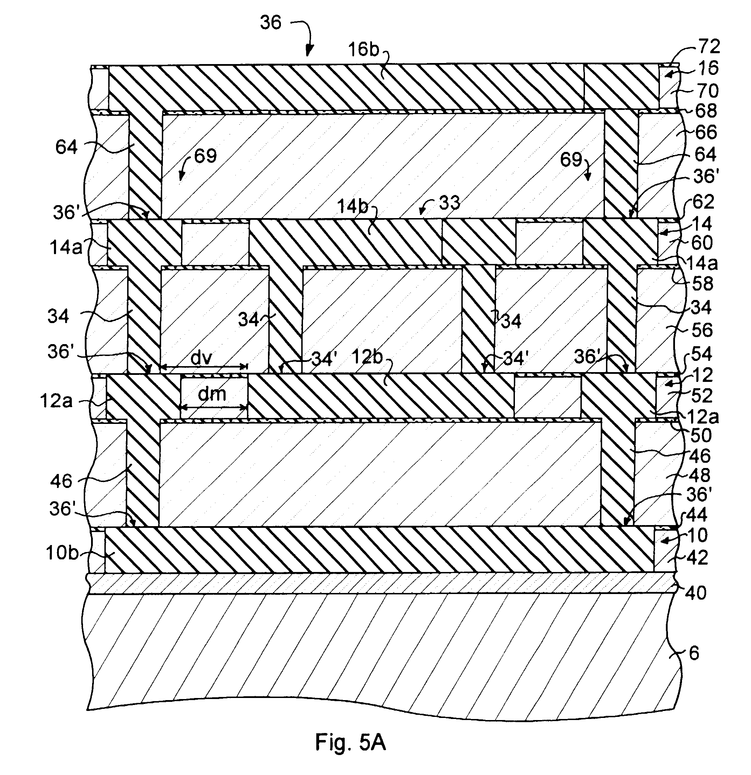

La figure 5A représente un deuxième mode de réalisation de la structure de transformateur selon l'invention. Dans ce mode de réalisation de l'invention, on utilise un processus dit double damascène. La première couche conductrice 10 est formée comme cela a été décrit en relation avec la figure 4A. Ensuite, sont formées la première couche isolante 48 et la deuxième couche de masquage 50. La deuxième couche de masquage 50 est gravée, mais la première couche isolante 48 n'est pas gravée à cette étape. La deuxième couche diélectrique 52 et la troisième couche de masquage 54 sont formées. La troisième couche de masquage 54 est gravée. En une unique étape, la deuxième couche diélectrique 52 est gravée par l'intermédiaire de la troisième couche de masquage 54 et la première couche isolante 48 est gravée par l'intermédiaire de la deuxième couche de masquage 50. Les cavités résultantes définissent le positionnement des vias 46 et des lignes conductrices de la deuxième couche 12. Les deux sont remplies simultanément par un dépôt de matériau conducteur. Il peut s'agir d'un dépôt chimique en phase vapeur (CVD), d'un recouvrement de métal par pulvérisation à chaud ou de tout autre procédé approprié. Le matériau conducteur en excès est alors enlevé de la surface de la couche de masquage 54, comme cela a été décrit en relation avec la figure 4A. Les plots conducteurs 12a et les vias sous-jacents 46 sont d'une seule pièce en un unique matériau conducteur. Chaque ensemble de ce type est en contact direct avec une ligne conductrice sous-jacente 10b de la première couche 10.

Un procédé similaire est utilisé pour définir :
- les vias 34 et la troisième couche conductrice 14 par l'intermédiaire de la deuxième couche isolante 26 et de la troisième couche diélectrique 60, en utilisant des quatrième et cinquième couches de masquage 58, 62 ; et
- les vias 64 et la quatrième couche conductrice 16 par l'intermédiaire d'une troisième couche isolante 66 et d'une quatrième couche diélectrique 70, en utilisant des sixième et septième couches de masquage 68, 72. Chaque ensemble d'un via et d'un plot 12a ainsi formé a une résistance série typiquement de l'ordre de 0,2 Ω.

Dans les modes de réalisation décrits ci-dessus, les couches diélectriques et isolantes 42, 48, 52, 56, 60, 66, 70 peuvent être en oxyde de silicium ou en un matériau vitreux à base d'oxyde de silicium tel que TEOS, PSG, BPSG. Les couches de masquage 44, 50, 54, 58, 62, 68, 72 peuvent être en nitrure de silicium ou en tout matériau électriquement isolant et gravable sélectivement par rapport aux matériaux des couches diélectriques, isolantes et conductrices. Les couches diélectriques 10, 12, 14, 16 peuvent être en tout matériau métallique à faible résistivité, par exemple de l'aluminium, du cuivre ou du tungstène.

La couche d'oxyde de champ 40 peut être en oxyde de silicium et le substrat 6 peut être en silicium.

Comme on le voit en figure 5A, dans ce mode de réalisation l'enroulement primaire 33 comprend seulement deux surfaces de contact 34' par tour et l'enroulement secondaire 36 comporte seulement six surfaces de contact 34' par tour. Ainsi, le mode de réalisation de la figure 5A comporte un nombre de surfaces de contact égal à la moitié de celui du mode de réalisation de la figure 4A. La résistance de chaque tour de chaque enroulement est ainsi réduite de la moitié de la contribution des résistances de contact. Le facteur de mérite de la structure de transformateur résultante est en conséquence amélioré.

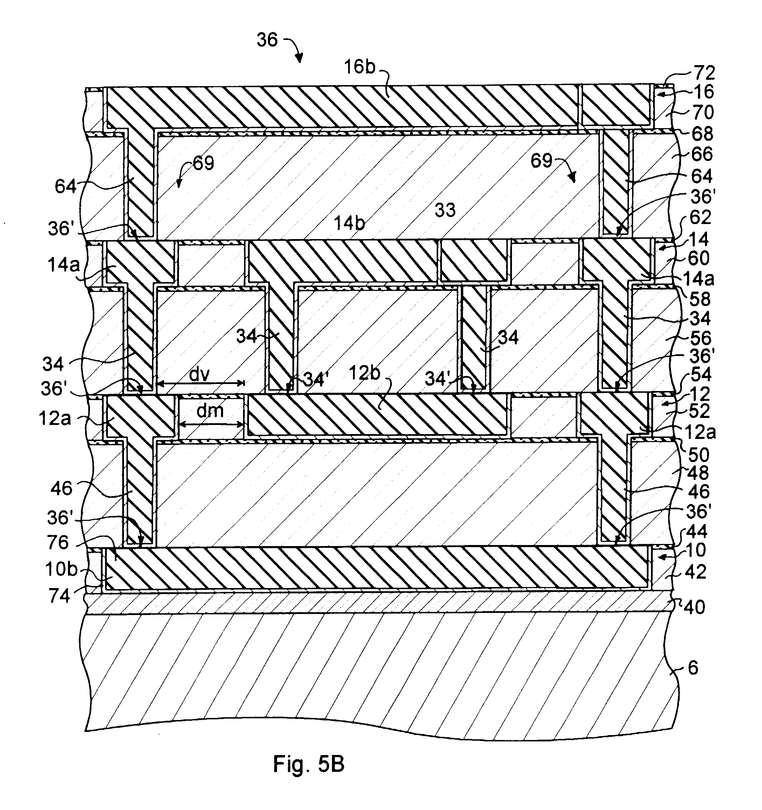

La figure 5B représente une variante du mode de réalisation de la figure 5A, similaire à la variante représentée en figure 4B du mode de réalisation de la figure 4A. Après gravure de la première couche diélectrique 42 pour former des cavités selon le motif requis de la première couche conductrice 10, une couche mince de revêtement 74 est déposée dans les cavités. Après ce dépôt, un matériau très conducteur 76 est déposé, pour recouvrir la couche de revêtement 74 et remplir les cavités. Des parties de la couche de revêtement 74 et du matériau conducteur 76 restant sur la couche de masquage 44 ailleurs qu'à l'intérieur des cavités sont enlevées par polissage ou gravure humide ou à sec. Plus tard dans le procédé de fabrication, quand la première couche isolante 48 et la deuxième couche diélectrique 52 sont gravées en utilisant les deuxième et troisième couches de masquage 50, 54, on répète la séquence consistant à déposer la couche de masquage 74, à déposer du matériau conducteur 76 et à enlever les couches de revêtement et conductrices ailleurs que dans les cavités gravées.

La séquence de gravure des cavités à travers les deux couches diélectriques, en utilisant deux couches de masquage, en déposant une couche de revêtement 74, en déposant une autre couche conductrice 76 et en enlevant le revêtement et les autres couches conductrices ailleurs que dans les cavités gravées est également répété pour :
- définir des vias 34 et une troisième couche conductrice 14 dans la deuxième couche isolante 56 et la troisième couche diélectrique 60, à travers les couches de masquage 58, 62 ; et
- définir des vias 64 et une quatrième couche conductrice 16 dans la troisième couche isolante 66 et la quatrième couche diélectrique 70, à travers les couches de masquage 68, 72.

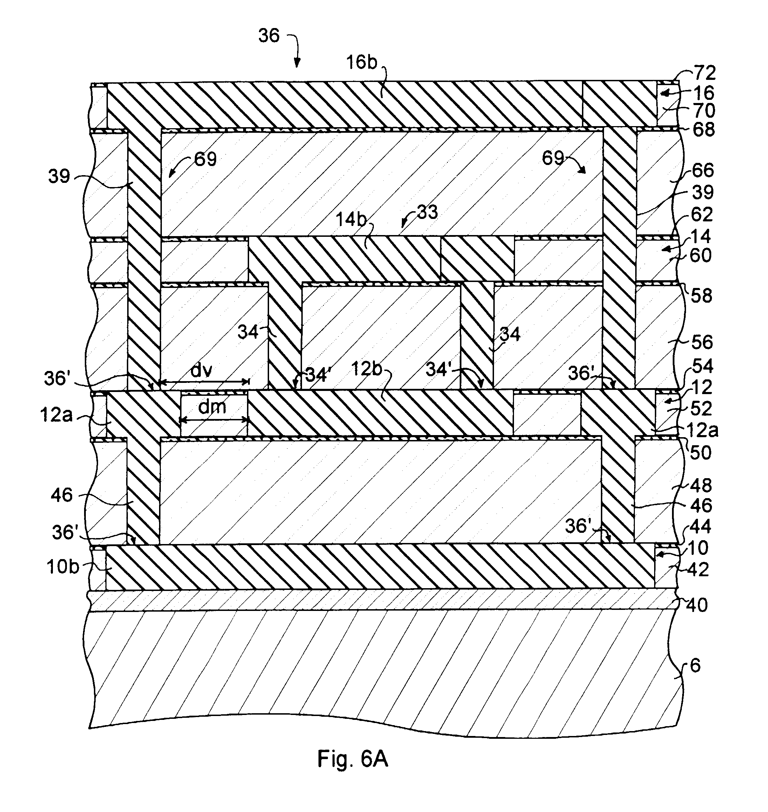

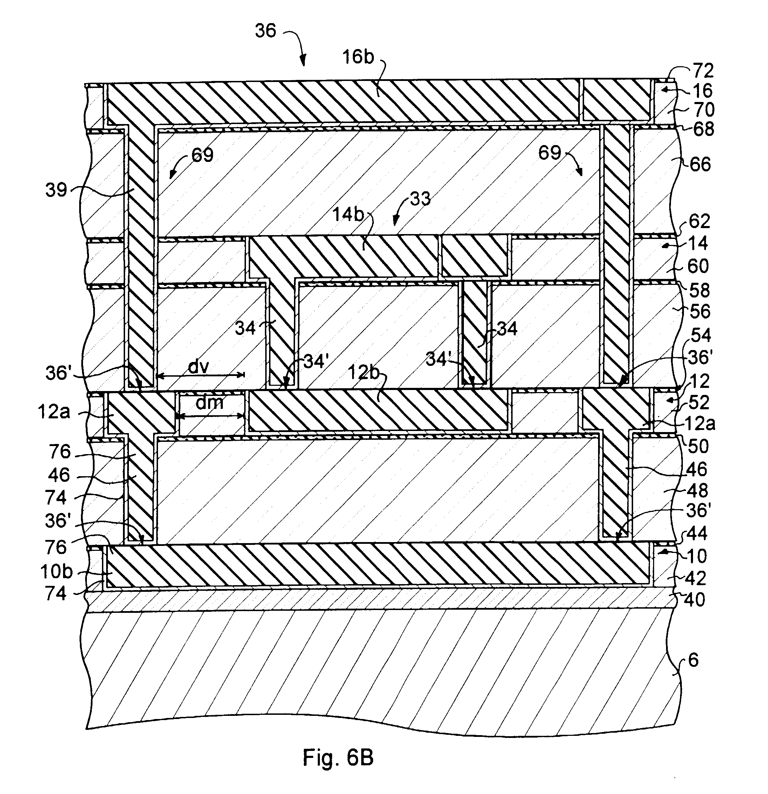

En utilisant les matériaux préférés, une couche 74 de TiN de 10 nm et du cuivre 76 comme matériau conducteur, la plus grande partie de la résistance de chaque enroulement correspond aux résistances de contact de chaque surface de contact. Ceci est largement dû au fait que TiN a une résistivité beaucoup plus élevée que celle du cuivre. Dans le mode de réalisation de la figure 6, seulement six résistances de contact sont incluses pour chaque tour d'enroulement secondaire 36 et seulement quatre résistances de contact sont incluses pour chaque tour d'enroulement primaire 33. Ceci réduit notablement la résistance de chaque enroulement et améliore le facteur de mérite de la structure de transformateur résultante.

La figure 6A représente un autre mode de réalisation de l'invention. La première couche conductrice 10 est formée dans la première couche diélectrique 42 par tout procédé convenable, par exemple, par le procédé simple damascène décrit ci-dessus. Les vias 46 et la deuxième couche conductrice sont formés d'une seule pièce dans les couches 48, 52 en utilisant des couches de masquage 50, 54 par le procédé double damascène tel que décrit en relation avec la figure 5A. Les couches 56 et 60 sont alors déposées, en concordance avec les quatrième et cinquième couches de masquage 58, 62. Les vias 34 et les parties de couches conductrices 14 de l'enroulement primaire 33 sont respectivement formés dans la deuxième couche isolante 56 et la troisième couche diélectrique 60. Toutefois, les vias ne sont pas formés à cette étape pour l'enroulement secondaire 36.

La couche 66 est déposée. La sixième couche de masquage 68 est déposée et est gravée selon un motif représentant les emplacements requis des vias 39.

La couche 70 est déposée, puis la septième couche de masquage 72. La septième couche de masquage 72 est alors gravée selon un motif présentant la configuration requise de la quatrième couche conductrice 16. Une gravure anisotrope, unique et sélective par rapport aux matériaux des couches diélectriques et isolantes, est appliquée à la structure. Des cavités sont formées dans la quatrième couche diélectrique 70 pour correspondre aux motifs requis de la quatrième couche conductrice 16. Des cavités sont formées dans les emplacements requis des vias 39. Cette gravure est poursuivie suffisamment longtemps pour creuser les cavités des vias à travers les couches 66, 60, 56 et les cinquième et quatrième couches de masquage 62, 58. Les sixième et septième couches de masquage 68, 72 doivent ou bien être en un matériau différent, gravable sélectivement par rapport aux autres couches de masquage 58, 62, ou bien être plus épaisses que les autres couches de masquage 58, 62 si elles sont constituées du même matériau. Plusieurs étapes de gravures différentes doivent être utilisées pour graver de façon alternée le matériau de la couche diélectrique, le matériau de la couche isolante et le matériau de la couche de masquage, ou bien un produit de gravure unique doit être utilisé qui puisse graver de façon anisotrope tous ces matériaux.

Un matériau conducteur est ensuite déposé dans le via et les cavités de lignes conductrices pour former d'une seule pièce les vias 39 et les lignes conductrices 16B. Ceci peut être réalisé par CVD ou par application d'un métal par pulvérisation à chaud ou par tout autre procédé adapté.

La figure 6B représente un autre mode de réalisation de l'invention à savoir une variante du mode de réalisation de la figure 6A. Après gravure à travers la première couche diélectrique 42 selon le motif requis pour la première couche conductrice 10, une couche mince de revêtement 74 est déposée dans la cavité. Après ce dépôt, on dépose un matériau très conducteur 76 pour recouvrir la couche de revêtement 74 et remplir la cavité. Des parties de la couche de revêtement 74 et d'un autre matériau conducteur 76 restant sur la couche de masquage 44 ailleurs que dans la cavité sont enlevées par polissage ou gravure humide ou à sec. Lors d'une étape ultérieure de fabrication, quand la deuxième couche diélectrique 52 est gravée à travers le troisième masque 54, la séquence de dépôt de la couche de revêtement 74, de dépôt de l'autre couche conductrice 76 et d'enlèvement des couches de revêtement et conductrice, ailleurs que dans les cavités gravées, est répétée, pour former de façon unitaire les lignes conductrices 12a, 12b et les vias 46.

La séquence consistant à déposer la couche de revêtement 74, à déposer la couche conductrice 76 et à enlever les couches de revêtement et conductrice ailleurs que dans la cavité gravée est également répétée pour :
- définir et former de façon unitaire des vias 34 et des lignes conductrices 14b de la troisième couche 14 dans les couches 56, 60 à travers les couches de masquage 58, 62 ; et
- définir et former de façon unitaire les vias 39 et les lignes conductrices 16b de la quatrième couche 16 dans les couches 56, 60, 66, 70, à travers les couches de masquage 68, 72.

Dans ce mode de réalisation, les vias 39 prennent la place de deux vias empilés 34, 64 dans les modes de réalisation décrits précédemment. Comme la résistance série d'un via est essentiellement déterminée par le matériau 36' de la surface de contact, les vias 39 ont sensiblement la même résistance que les vias 34, à savoir environ 0,2 Ω, mais répartie sur deux couches de vias. Ceci équivaut à une résistance de 0,1 Ω par couche de vias, pour des vias d'une section de 0,4 µm x 0,4 µm.

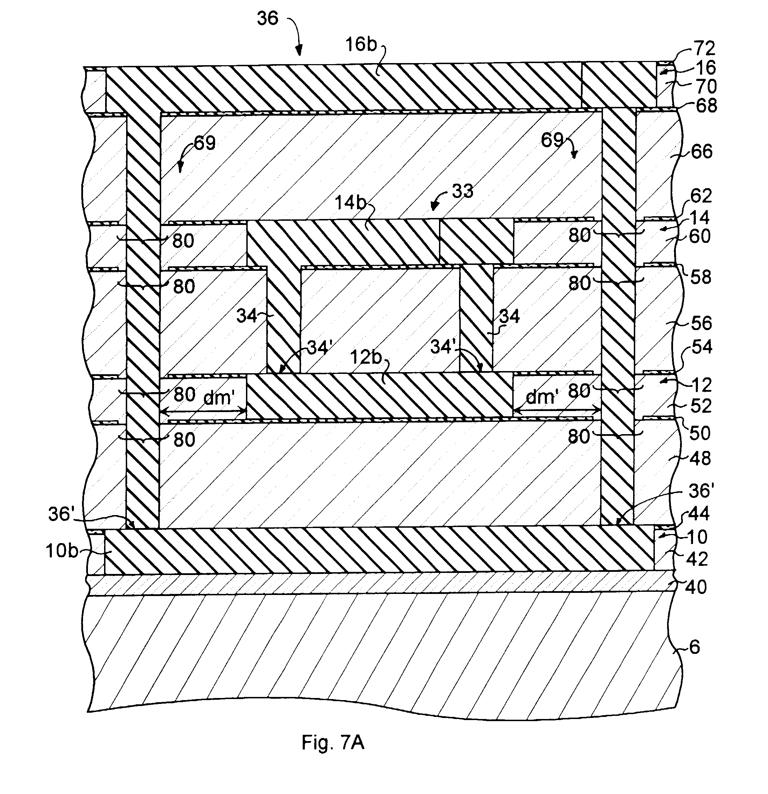

La figure 7A représente un autre mode de réalisation de la présente invention. La première couche conductrice 10 est formée dans la première couche diélectrique 42 par tout procédé adapté, tel que par le procédé simple damascène décrit ci-dessus. Toutefois, les vias ne sont pas initialement formés dans la première couche isolante 48. Aux emplacements où des vias 69 doivent traverser la première couche isolante 48, des trous agrandis 80 sont formés dans la première couche de masquage 50. Tandis que le procédé de fabrication se continue, la deuxième couche conductrice 12 est formée dans la deuxième couche diélectrique par une étape simple damascène, sans gravure de la première couche isolante. Ceci peut par exemple être réalisé en masquant sélectivement les trous agrandis 80 en utilisant une résine photosensible. Les vias 34 et la troisième couche conductrice 14 de l'enroulement primaire sont formés par le procédé simple ou double damascène décrit ci-dessus. A nouveau aucune cavité de via n'est gravée dans la première couche isolante 48. A chaque étape concernée, des trous agrandis 80 sont recopiés dans les troisième, quatrième et cinquième couches de masquage 54, 58, 62.

La troisième couche isolante 66 est déposée. La sixième couche de masquage 68 est déposée et est gravée aux emplacements requis des vias 69.

La quatrième couche diélectrique 70 est déposée, suivie de la septième couche de masquage 72. La septième couche de masquage 72 est alors gravée selon la configuration requise de la quatrième couche conductrice 16. Une gravure anisotrope unique, sélective par rapport au matériau des couches diélectriques, est appliquée à la structure. Des cavités sont formées aux emplacements des vias 69. Cette gravure se continue suffisamment longtemps pour creuser des cavités dans les couches 66, 60, 56, 52, 48. Comme on le notera, par suite des erreurs d'alignement inhérentes à de tels procédés, les trous élargis 80 sont nécessaires pour assurer que les cavités atteignent la première couche conductrice 10 avec la même section que les motifs définis sur la couche de masquage 68. Un matériau conducteur est alors déposé dans les cavités gravées pour former d'une seule pièce les vias 69 et les lignes conductrices 16b. Ceci peut être réalisé par CVD ou par pulvérisation à chaud d'un métal ou par tout autre procédé convenable. Les éléments constitués de la ligne conductrice 16b et des vias 69 sont en contact électrique direct avec la ligne conductrice 10b de la première couche 10.

A titre de variante, le procédé décrit en relation avec la figure 6A peut être utilisé, d'où il résulte que le motif des vias 69 est défini seulement dans la sixième couche diélectrique 68, une gravure anisotrope étant alors appliquée pour graver à travers tout l'ensemble des couches diélectriques, d'isolement et de masquage pour atteindre la première couche conductrice 10. Dans ce procédé, les sixième et septième couches de masquage 68, 72 doivent être en un matériau différent de celui des autres couches de masquage et gravables sélectivement par rapport au matériau des autres couches de masquage, elles peuvent également être plus épaisses que les autres couches de masquage si elles sont en le même matériau. Le mode de réalisation de la figure 6A pourrait également être utilisé de la même façon que cela a été décrit en relation avec la figure 7A en définissant des trous agrandis 80 sur les couches de masquage 58, 62, avant de graver des cavités pour les vias 39.

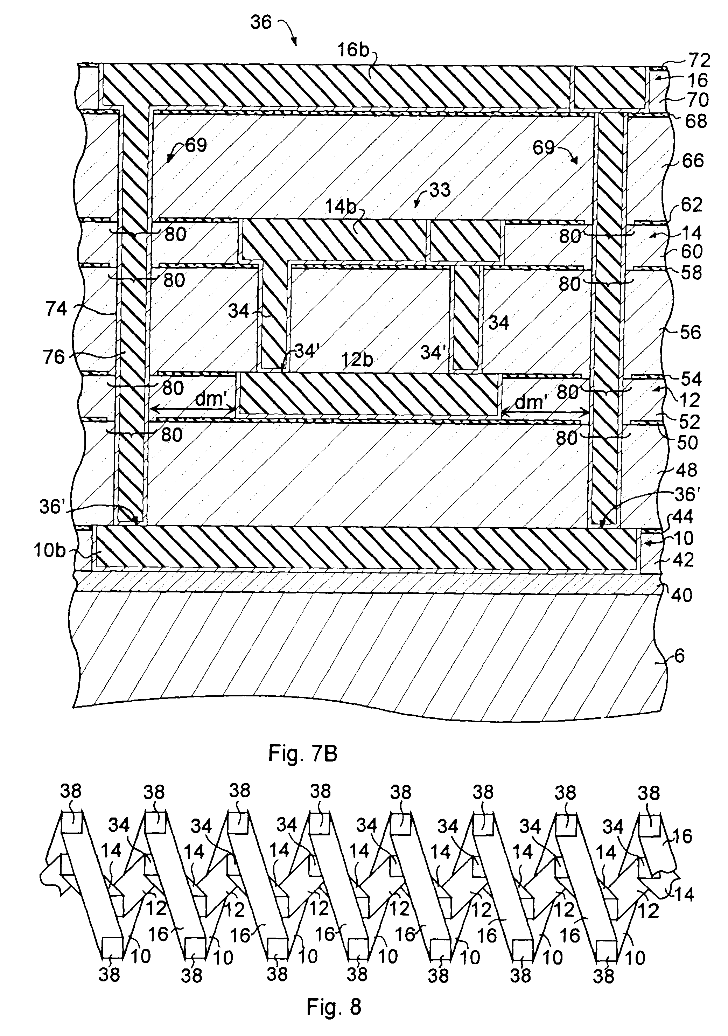

La figure 7B représente un autre mode de réalisation de l'invention. De façon similaire au mode de réalisation de la figure 6B, cette figure 7B représente une variante du mode de réalisation de la figure 7A. Après gravure à travers la première couche diélectrique 42 selon le motif requis pour la première couche conductrice 10, une couche mince de revêtement 74 est déposée dans la cavité. Après ce dépôt, on dépose un matériau très conducteur 76 pour recouvrir la couche de revêtement 74 et remplir la cavité. Des parties de la couche de revêtement 74 et un autre matériau conducteur 76 restant sur la couche de masquage 44 ailleurs que dans la cavité sont enlevés par polissage ou gravure humide ou sèche. Lors d'une étape ultérieure de fabrication, quand la couche 52 est gravée à travers la troisième couche de masquage 54, la séquence consistant à déposer la couche de revêtement 74, à déposer la couche conductrice 76 et à enlever les couches de revêtement et conductrices ailleurs que dans les cavités gravées est répétée.

La séquence de dépôt d'une couche de revêtement 74, de dépôt d'une couche conductrice 76 et d'enlèvement de la couche de revêtement et de la couche conductrice ailleurs que dans la cavité gravée est également répétée pour :
- définir des vias 34 et une troisième couche conductrice 14 dans les couches 56, 60 à travers les couches de masquage 58, 62 ; et
- définir les vias 69 et la quatrième couche conductrice 16 dans les couches 48, 52, 56, 60, 66, 70 à travers les couches de masquage 68, 72 pour former d'une seule pièce les vias 69 et la ligne conductrice 16b. Chacun des ensembles constitué des vias 69 et de la ligne conductrice 16b est en contact électrique direct avec les lignes correspondantes 10b de la première couche 10.

Ce mode de réalisation est particulièrement avantageux car chaque tour de l'enroulement secondaire 36 comprend seulement deux interfaces de contact 36' à la place des six vias représentés en figures 4A-4B. En outre aucun plot métallique 12a, 14a n'est nécessaire sur les deuxième et troisième niveaux pour les vias reliant les quatrième et premier niveaux. Ceci est avantageux car la structure de la figure 7B peut être dense. Dans le mode de réalisation de la figure 4A, par exemple, l'espace minimum possible dm entre des motifs de la deuxième couche d'interconnexion 12 définit la largeur de l'enroulement secondaire 36. L'espace dv entre une métallisation de l'enroulement primaire 33 de la deuxième couche conductrice 12 et un via 34 de l'enroulement secondaire est nettement supérieur à dm.

Dans le mode de réalisation de la figure 7B, l'espace dm' entre une métallisation de l'enroulement primaire et le via correspondant 38 de l'enroulement secondaire 36 peut être sensiblement la dimension minimale dm. Ceci conduit à une densité plus grande de la structure, à un coefficient de couplage accru, à un facteur de mérite accru et à une consommation réduite de surface de substrat.

Typiquement, une structure de transformateur selon l'invention peut avoir une largeur de 6 à 7 µm, une hauteur de 5 µm (ceci étant défini par les épaisseurs des couches utilisées dans le procédé de fabrication de la structure) et une longueur définie par le nombre de tours requis de chacun des enroulements primaire et secondaire.

Le facteur de mérite du transformateur selon l'invention pourrait être augmenté par l'utilisation de matériaux diélectriques à faible permittivité (faible ε). L'utilisation de tels matériaux pour les couches diélectriques et isolantes réduit la capacité parasite de couplage entre les enroulements 33, 36 et la capacité parasite entre tours d'un même enroulement.

Bien que tous les modes de réalisation décrits ci-dessus utilisent des lignes en forme de L au niveau de chaque couche conductrice pour former les enroulements, un transformateur selon l'invention peut être constitué en utilisant diverses autres formes. Par exemple des vias successifs peuvent être connectés les uns aux autres par des lignes sensiblement droites dans une couche conductrice, de sorte que dans une vue de dessus chaque tour aura une forme de V.

La figure 8 représente une vue de dessus d'un tel agencement possible dans lequel des vias successifs dans les deux enroulements sont reliés par des lignes sensiblement droites dans la couche conductrice concernée 10, 12, 14, 16. Le facteur de couplage entre les deux enroulements d'une telle structure sera différent de celui des modes de réalisation décrits précédemment.

La présente invention atteint donc les objets visés à savoir :
on obtient une structure de transformateur dans un circuit intégré, dans laquelle le couplage entre les enroulements primaire et secondaire est élevé en raison de la proximité des enroulements primaire et secondaire ;
on obtient un structure de transformateur avec un champ électromagnétique sensiblement parallèle à la surface supérieure de substrat, d'où il résulte que l'on réduit l'émission de champ électromagnétique dans le substrat ;
on obtient une structure de transformateur qui occupe une surface réduite sur le substrat par rapport aux transformateurs intégrés connus ;
on obtient une structure de transformateur compatible avec des procédés classiques de fabrication de circuits intégrés et qui ne nécessite pas d'étape de traitement particulière ou de matériau spécifique.

L'utilisation du procédé double damascène ou la formation de vias damascène à travers plusieurs couches en une seule étape réduit la résistance des enroulements de façon suffisante pour former un transformateur efficace utilisant plusieurs couches conductrices.

Bien que l'invention ait été décrite dans le cas d'un enroulement primaire disposé à l'intérieur d'un enroulement secondaire plus grand, les fonctions des deux enroulements peuvent être inversées de sorte que l'enroulement secondaire peut être prévu à l'intérieur d'un enroulement primaire plus grand.

## Revendications

1. Transformateur formé dans un circuit intégré comprenant un substrat de surface supérieure horizontale, caractérisé en ce qu'il comprend :
- une première pluralité de lignes conductrices (10b) disposées en une première couche (10) sur la surface supérieure du substrat ;
- une deuxième pluralité de lignes conductrices (12b) disposées en une deuxième couche (12), séparées verticalement de la première pluralité de lignes conductrices par une première couche isolante (48) ;
- une troisième pluralité de lignes conductrices (14b) disposées en une troisième couche (14), séparées verticalement de la deuxième pluralité de lignes conductrices par une deuxième couche isolante (56) ;
- une quatrième pluralité de lignes conductrices (16b) disposées en une quatrième couche (16), séparée verticalement de la troisième pluralité de lignes conductrices par une troisième couche isolante (66) ;
- des premiers vias conducteurs (34) s'étendant à travers la deuxième couche isolante (56), reliant les deuxième et troisième pluralité de lignes conductrices, d'où il résulte que les deuxième et troisième pluralité de lignes conductrices et les premier vias conducteurs forment un premier enroulement (33) ; et
- des deuxièmes vias conducteurs (38) s'étendant à travers les première, deuxième et troisième couches isolantes, reliant les première et quatrième pluralités de lignes conductrices, d'où il résulte que les première et quatrième pluralités de lignes conductrices et les deuxièmes vias conducteurs forment un second enroulement (36) autour du premier enroulement et de façon sensiblement concentrique à celui-ci.

2. Transformateur selon la revendication 1, dans lequel les axes des premier et second enroulements sont sensiblement parallèles à la surface supérieure du substrat.

3. Transformateur selon la revendication 1, dans lequel chacune de la quatrième pluralité de lignes conductrices est constituée d'une seule pièce avec au moins une partie (64, 39) des deuxièmes vias conducteurs sous-jacents (69).

4. Transformateur selon la revendication 1, dans lequel chacune de la troisième pluralité de lignes conductrices est constituée d'une seule pièce avec les premiers vias conducteurs sous-jacents (34), ces ensembles étant en contact électrique direct avec des lignes conductrices respectives sous-jacentes de la deuxième pluralité de lignes conductrices.

5. Transformateur selon la revendication 1, dans lequel les deuxièmes vias conducteurs (69) comprennent des plots (12a, 14a) dans les deuxième et troisième couches (12, 14), chaque plot étant constitué d'une seule pièce avec une partie sous-jacente (46, 34) des deuxièmes vias conducteurs respectifs (69).

6. Transformateur selon la revendication 1, dans lequel chacune de la quatrième pluralité de lignes conductrices est constituée d'une seule pièce avec les deuxièmes vias conducteurs sous-jacents (69), ces ensembles étant en contact électrique direct avec des lignes respectives sous-jacentes de la première pluralité de lignes conductrices.

7. Transformateur selon la revendication 1, dans lequel les lignes conductrices et les vias conducteurs sont essentiellement constitués de cuivre.

8. Transformateur selon la revendication 1, dans lequel les lignes conductrices et les vias conducteurs sont essentiellement constitués d'aluminium.

9. Transformateur selon la revendication 7 ou 8, dans lequel les lignes conductrices et les vias conducteurs comprennent en outre une couche de revêtement (74) en nitrure de titane, encapsulant les lignes conductrices et les vias conducteurs (76) sur toutes leurs surfaces autres que leurs surfaces supérieures.

10. Transformateur selon la revendication 1, dans lequel chaque tour de chaque enroulement comprend seulement deux surfaces de contact (34', 36').

11. Procédé de fabrication de transformateurs dans des circuits intégrés, caractérisé en ce qu'il comprend les étapes suivantes :
a) former une première couche diélectrique (42) sur une surface supérieure d'un substrat (6) ;
b) graver la première couche diélectrique selon un motif pour former des cavités qui correspondent à un agencement désiré de premières lignes conductrices ;
c) remplir les cavités dans la première couche diélectrique pour former une première pluralité de lignes conductrices (10b) disposées en une première couche (10) ;
d) déposer une première couche isolante (48) ;
e) former une deuxième couche diélectrique (52) sur la surface supérieure de la structure résultante ;
f) graver la deuxième couche diélectrique selon un motif pour former des cavités correspondantes à un agencement désiré de deuxièmes lignes conductrices ;
g) remplir les cavités dans la deuxième couche diélectrique pour former une deuxième pluralité de lignes conductrices (12a, 12b) agencées en une deuxième couche (12) ;
h) déposer une deuxième couche isolante (56) ;
i) former une troisième couche diélectrique (60) sur la surface supérieure de la structure résultante ;
j) graver la troisième couche diélectrique selon un motif pour former des cavités qui correspondent à un agencement désiré de troisièmes lignes conductrices ;
k) remplir les cavités dans la troisième couche diélectrique pour former une troisième pluralité de lignes conductrices (14a, 14b) agencées en une troisième couche (14) ;
l) déposer une troisième couche isolante (66) ;
m) former une quatrième pluralité de lignes conductrices (16b) agencées en une quatrième couche ;
n) entre les étapes h) et l), mettre en oeuvre les étapes suivantes :
n1) former des cavités dans la deuxième couche isolante selon un motif qui correspond aux emplacements requis des premiers vias conducteurs ;
n2) remplir les cavités dans la deuxième couche isolante d'un matériau conducteur pour former des premiers vias conducteurs (34) s'étendant à travers la deuxième couche isolante (56) pour connecter électriquement des lignes respectives des deuxième et troisième pluralités de lignes conductrices pour former un premier enroulement (33) ; et
p) entre les étapes d) et m), mettre en oeuvre les étapes suivantes :
p1) former des cavités dans les première, deuxième et troisième couches isolantes selon un motif qui correspond aux emplacements requis des deuxièmes vias conducteurs ;
p2) remplir les cavités dans les première, deuxième et troisième couches isolantes d'un matériau conducteur pour former les premiers vias conducteurs (34) s'étendant à travers les première, deuxième et troisième couches isolantes pour connecter électriquement des lignes respectives des première et quatrième pluralités de lignes conductrices de façon à former un second enroulement (36) autour du premier enroulement et de façon sensiblement concentrique à celui-ci.

12. Procédé selon la revendication 11, dans lequel l'étape m) comprend les étapes suivantes :
m1) former une quatrième couche diélectrique (70) sur la surface supérieure d'un substrat ;
m2) graver la quatrième couche diélectrique selon un motif pour former des cavités qui correspondent à un agencement désiré de quatrièmes lignes conductrices ;
m3) remplir les cavités dans la quatrième couche diélectrique pour former la quatrième pluralité de lignes conductrices.

13. Procédé selon la revendication 11, dans lequel, à l'étape p1), les cavités sont formées dans les première, deuxième et troisième couches isolantes en une seule étape.

14. Procédé selon la revendication 11, dans lequel, à l'étape p2), le remplissage des cavités dans les première, deuxième et troisième couches isolantes est réalisé en une seule étape.

15. Procédé selon la revendication 11, dans lequel, à l'étape p2), le remplissage des cavités dans les première, deuxième et troisième couches isolantes est réalisé à l'étape m3).

16. Procédé selon la revendication 11 dans lequel, à l'étape p1), les cavités sont formées dans les deuxième et troisième couches isolantes en une seule étape.

17. Procédé selon la revendication 11 dans lequel, à l'étape p2), le remplissage des cavités dans les deuxième et troisième couches isolantes est réalisé en une seule étape.

18. Procédé selon la revendication 17 dans lequel, à l'étape p2), le remplissage des trous dans les deuxième et troisième couches isolantes est réalisé à l'étape m3).
